# FASCICULE DE BREVET EUROPEEN

(11) **EP 2 186 081 B1**
(45) Date de publication et mention de la délivrance du brevet: **01.01.2014**
(21) Numéro de dépôt: 08803834.4
(22) Date de dépôt: 08.09.2008
(51) Int. Cl.: G09G 3/20, G09G 3/36, G11C 19/18, G11C 19/28

(54) **REGISTRE A DECALAGE POUR UN ECRAN PLAT A MATRICE ACTIVE**
SCHIEBEREGISTER FÜR EINEN AKTIVMATRIXFLACHBILDSCHIRM
SHIFT REGISTER FOR AN ACTIVE-MATRIX FLAT SCREEN

(30) Priorité: 07.09.2007 FR 0706281
(43) Date de publication de la demande: 19.05.2010
(73) Titulaire: THALES, 92200 Neuilly-sur-Seine (FR)
(72) Inventeur: KRETZ, Thierry, F-38430 Saint Jean De Moirans (FR); VOISIN, Gérard, F-33160 St Medard En Jalles (FR)
(74) Mandataire: Bréda, Jean-Marc
(86) Numéro de dépôt international: PCT/EP2008/061866
(87) Numéro de publication internationale: WO 2009/030776

(56) Documents cités:
- WO-A-97/25716
- WO-A-2006/013542

## Description

La présente invention concerne un perfectionnement des circuits de commande des lignes de sélection d'une matrice active d'un écran à plat, et plus particulièrement un perfectionnement de circuits de commande intégrés à la matrice active. Elle s'applique aux différentes technologies d'écrans plats à matrice active, notamment aux technologies cristal liquide, OLED (*Organic light-emitting diode*).

Dans une matrice active à circuits de commande périphériques intégrés, les électrodes pixels et les transistors de commutation associés des points image, ainsi que les circuits de commande des lignes et des colonnes d'électrodes pixel sont réalisés en même temps sur le même substrat.

Les circuits de commande des lignes communément appelés *"drivers lignes"* dans la littérature technique, permettent à chaque nouvelle trame vidéo à afficher, d'appliquer les signaux de sélection de ligne l'un après l'autre suivant un sens de balayage des lignes de l'écran.

Ces circuits de commande comprennent à cet effet un ou plusieurs registres à décalage en série, chaque étage de sortie des registres délivrant le signal de sélection d'une ligne de la matrice donnée.

On connaît de la demande de brevet EP 0815 562 (WO 97/25716), une structure à transistors et capacités d'autoélévation dites de "*bootstrap*", avantageusement simple pour réaliser les étages d'un registre à décalage, qui permet de bénéficier d'un effet d'élévation de tension intéressant, pour fournir le niveau élevé de tension attendu sur les lignes de la matrice, tout en limitant le stress sur les transistors de l'étage. Elle permet d'utiliser la même technologie de transistors pour le registre et pour la matrice active, notamment des transistors en couches minces de silicium amorphe hydrogéné. Cette structure permet de travailler avec des signaux de commande en entrée de chaque étage, ayant une amplitude inférieure à celle des signaux de sortie du registre, limitant le stress sur les grilles des transistors de l'étage. En outre la structure assure le blocage des transistors des étages non sélectionnés. De cette façon la fiabilité de ces registres à décalage est améliorée. Cette structure de registre à décalage est biphasée, c'est à dire qu'elle est pilotée par deux horloges complémentaires, dont les rôles s'inversent entre chaque étage. Ceci permet d'assurer un rapport cyclique des transistors qui est très faible, et donc d'assurer sensiblement la même durée de vie aux transistors du registre à décalage qu'aux transistors de commutation de la matrice active.

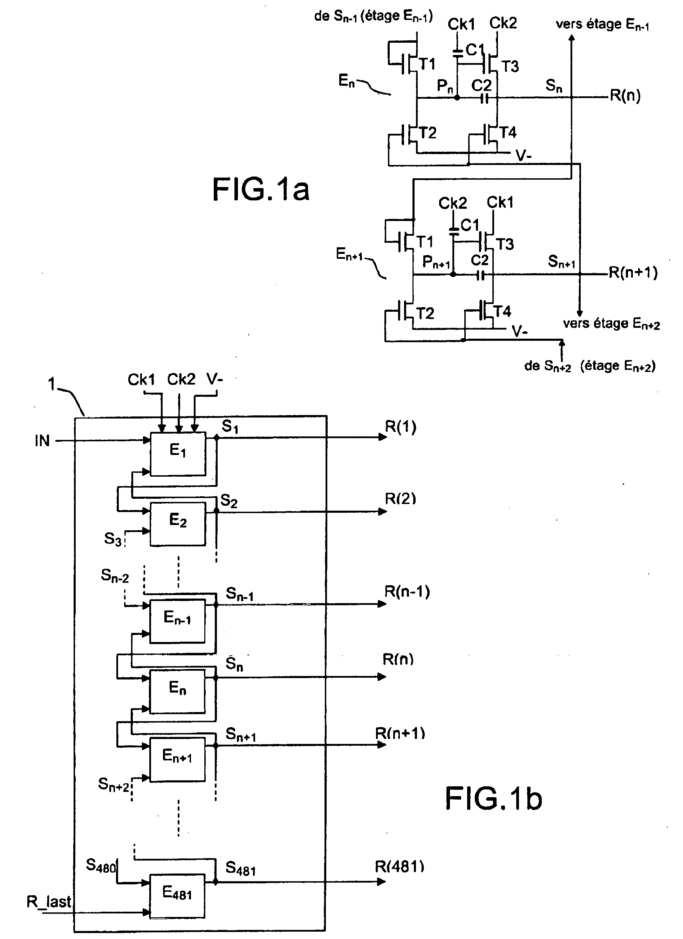

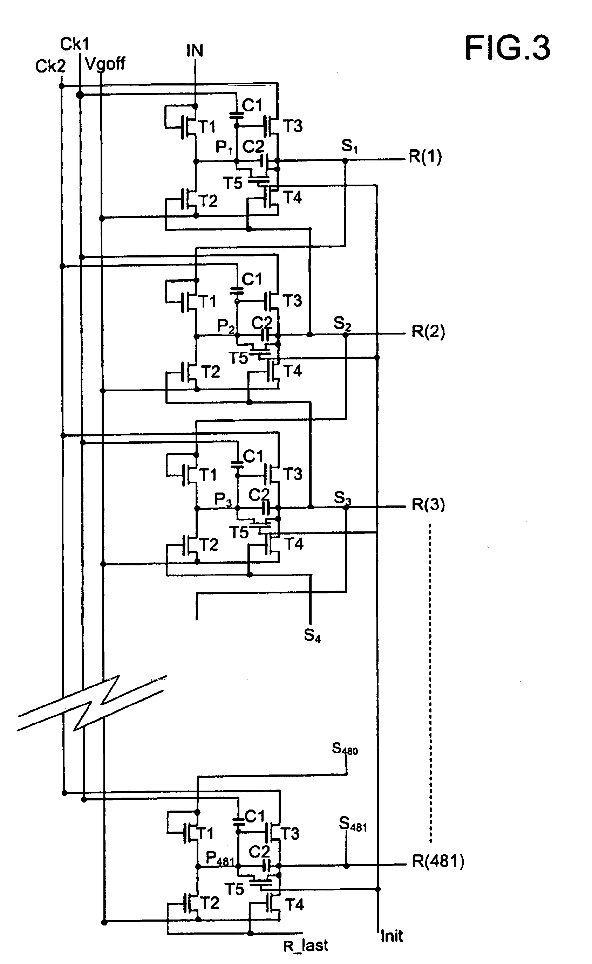

Cette structure est rappelée ci-après, en référence aux figures 1a et 1 b, dérivées de la figure 3 de la demande européenne précitée.

On note R(n), la nième ligne de la matrice active, et En l'étage du registre à décalage 1 commandant cette ligne R(n).

L'étage En est alimenté par une source négative V- amenée par un bus d'alimentation et séquencé par deux signaux d'horloges complémentaires Ck1 et Ck2. Il est connecté en entrées à une ligne précédente R(n-1) et à une ligne suivante R(n+1) de la matrice. La tension V-est typiquement égale à la tension de blocage Vgoff des transistors.

L'étage En (figure 1a) comprend quatre transistors T1, T2, T3 et T4, et deux capacités C1 et C2.

Les transistors T1 et T2 sont connectés en série, entre la ligne précédente R(n) et le potentiel V-. Le transistor T1 est monté en diode, sa grille étant connectée à son drain, et connectée à la ligne précédente R(n-1). La grille du transistor T2 est connectée à la ligne suivante R(n+1). Le noeud interne Pₙ correspond au noeud de connexion série des deux transistors T1 et T2, et pilote la grille G du transistor T3. Le transistor T1 monté en diode a une fonction de précharge de ce noeud interne Pₙ.

Les transistors T3 et T4 sont montés en série, entre un premier signal d'horloge, dans l'exemple Ck2, et le potentiel V-. Le transistor T3 est le transistor de commande de l'étage, ou transistor de "*drive*"*,* c'est à dire celui qui commande le noeud de sortie Sₙ connecté à la ligne de sélection R(n). Il est commandé sur sa grille par le potentiel au noeud interne Pₙ de l'étage. La grille du transistor T4 est connectée à la ligne suivante R(n+1).

La capacité C1 est pilotée par un signal d'horloge, dans l'exemple Ck1, et connectée au noeud interne Pₙ qui pilote la grille du transistor de drive T3. Cette capacité C1 a seulement une fonction de compensation, pour compenser la capacité parasite grille-drain du transistor de drive T3 lors de la commutation des signaux Ck1 et Ck2.

La capacité C2 est connectée entre le noeud interne Pₙ et le noeud de sortie Sₙ connectée à la ligne R(n).

D'un étage à l'autre, les rôles des signaux d'horloge Ck1 et Ck2 sont échangés : dans l'étage Eₙ₊₁ par exemple, c'est la capacité C1 qui reçoit le signal d'horloge Ck2 et le transistor de drive T3 qui reçoit le signal Ck1.

La figure 1b illustre schématiquement un registre à décalage 1 comprenant 481 étages. Le premier étage E₁ reçoit comme signal d'entrée appliqué à la grille du transistor T1 de précharge, le signal IN qui fournit l'impulsion de sélection ligne correspondant à une nouvelle trame vidéo.

Ce signal IN se propage de ligne en ligne, à la séquence ligne, par les étages E₁, E₂, ....Eₙ, ...E₄₈₁, en sorte que les lignes R(1) à R(481) sont chacune sélectionnées l'une après l'autre.

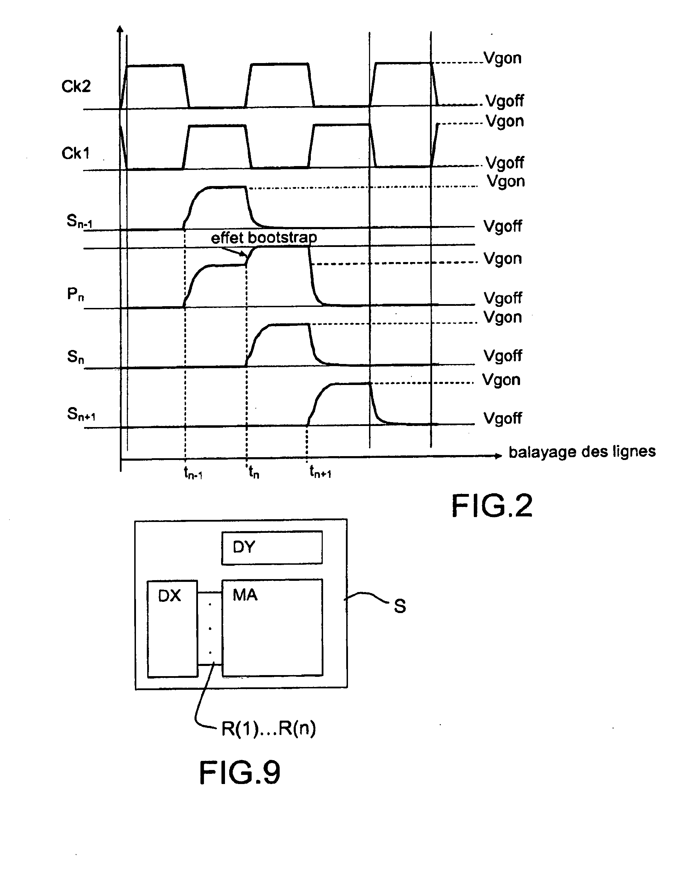

Le fonctionnement d'un étage de ce registre va maintenant être brièvement expliqué, en référence à l'étage En détaillé sur la figure 1a et au chronogramme de la figure 2.

Les signaux d'horloge Ck1 et Ck2 sont complémentaires, ie en opposition de phase. Typiquement le niveau haut de ces signaux est le niveau Vgon (par exemple 26 volts), et le niveau bas (V-), typiquement le niveau Vgoff (par exemple -7 volts).

La sélection de la ligne R(n) est faite lorsque le noeud de sortie Sₙ de l'étage Eₙ est porté au niveau haut Vgon.

Supposons que la ligne R(n) est sélectionnée pendant le temps ligne tₙ. La ligne R(n-1) a été sélectionnée sur le temps ligne précédent tₙ₋₁.

Pendant le temps ligne tₙ₋₁, les signaux d'horloge Ck1 et Ck2 sont respectivement à l'état haut Vgon et à l'état bas Vgoff et le noeud de sortie Sₙ₋₁ est à Vgon.

Pendant ce temps ligne, le transistor T1 (monté en diode) de l'étage En charge le noeud interne Pₙ de commande de grille du transistor de drive T3, au niveau Vgon - VtT1 du noeud de sortie Sₙ₋₁ de l'étage précédent (figure 1a), où VtT1 est la tension de seuil du transistor T1.

Au temps tₙ, l'état des signaux d'horloge Ck1 et Ck2 s'inverse.

Avec le signal d'horloge Ck2 repassant à l'état bas Vgoff, le noeud de sortie Sₙ₋₁ redescend à Vgoff : la ligne R(n-1) est désélectionnée. Le noeud de sortie Sₙ₋₁ repasse à Vgoff et le transistor T1 de l'étage En se bloque.

Le signal d'horloge Ck2 appliqué au transistor de drive T3 passe ainsi à l'état haut Vgon - VtT1 : le transistor de drive T3 passe à l'état passant. La tension au noeud interne Pₙ, qui commande la grille du transistor de drive T3, monte avec la tension de source (noeud Sₙ) du transistor T3 par effet dit de "bootstrap" par la capacité C2, ce qui maintient le transistor T3 de drive à l'état passant pendant le temps ligne tₙ.

Les transistors T2 et T4 de l'étage Eₙ₋₁ deviennent alors passants, car leurs grilles sont amenées à Vgon par le noeud de sortie Sₙ de l'étage En, ce qui tire le noeud interne Pₙ₋₁ et le noeud de sortie Sₙ₋₁ de l'étage Eₙ₋₁ à Vgoff : la ligne R(n-1) est désélectionnée et la capacité de bootstrap C2 déchargée.

Lorsque Ck1 remonte à Vgon et Ck2 redescend à Vgoff, la séquence se répète pour l'étage suivant en remplaçant n-1 par n, n par n+1 et Ck1 par Ck2 et vice versa. Ainsi, à chaque front des horloges Ck1 et Ck2, il y a propagation dans le registre à décalage d'une impulsion de sélection de ligne.

La séquence de balayage des lignes de la matrice débute par l'activation du signal IN, qui assure la précharge du noeud interne P₁ du premier étage.

Pour le dernier étage, un signal R-last doit être fourni, pour décharger le noeud interne P₄₈₁ du dernier étage, marquant la fin de la sélection de la ligne associée R(481) (cf figure 1 b).

Pour chaque trame vidéo à afficher correspondant à un temps trame, chacune des lignes R(1) à R(481) de la matrice est ainsi successivement sélectionnée par l'étage associé, chacune pendant un temps ligne.

Un fonctionnement correspondant est illustré par le chronogramme de la figure 2.

Lorsqu'un étage En n'est pas sélectionné, les deux transistors en série T1 et T2 tirent du courant de la ligne précédente R(n-1) vers Vgoff. Les deux transistors ont alors des tensions grille-source inférieures à leur tension de seuil, et leur courant de canal est une fonction exponentielle de ces tensions. Il résulte de cette disposition que la tension au noeud interne Pₙ est inférieure d'environ 1 volt à sa tension de source : le transistor T3 est à l'état bloqué. Ainsi, lorsqu'un étage du registre à décalage n'est pas sélectionné, ses transistors ont leur grille à une tension inférieure à leur tension de seuil, d'où une fatigue des transistors minimisée.

Ce registre à décalage selon l'état de l'art, ou des variantes de ce registre qui utilisent la structure de base qui vient d'être décrite, sont très utilisés. Les transistors du registre sont généralement réalisés dans la même technologie que ceux de la matrice active.

Il a cependant été observé un effet très gênant sur les écrans à matrice active dotés d'un tel registre à décalage pour commander les lignes. In s'agit d'un balayage inverse, du haut vers le bas, qui entraîne une double écriture de la vidéo pendant le temps trame, donnant une impression visuelle d'effet miroir de l'image à afficher.

Plus précisément, on peut constater que, alors que l'image s'affiche du haut vers le bas, et que le haut de l'écran s'affiche normalement, en parallèle, l'image est écrite du bas vers le haut : on peut ainsi observer un affichage partiel inversé au bas de l'écran de l'image qui s'affiche en haut de l'écran, avec une jonction proche du milieu de l'écran. Ceci conduit à cette impression d'effet miroir observé sur l'écran, entre le haut et le bas.

On a pu découvrir que cette double écriture est en fait initiée par la présence, dans certaines conditions, de charges dans les étages du registre à décalage, et plus particulièrement de charges sur la capacité C2 dite de bootstrap. On a pu mettre en évidence que ces charges ont pour effet de provoquer un balayage des lignes en sens inverse, activé par le signal R-last de décharge du dernier étage du registre à décalage. Une fois que ce balayage inverse démarre, il a en outre la particularité de s'auto-entretenir, en sorte que l'effet miroir est observé en permanence, de trame en trame.

De manière plus détaillée, on a pu mettre en évidence que cet effet miroir peut être déclenché par l'activation du signal R-last, lorsque dans les derniers étages du registre, des capacités de bootstrap C2 sont chargées à un niveau tel quel les transistors de drive T3 de ces étages se retrouvent polarisés au seuil de conduction, dans lequel ils ont un comportement linéaire.

Considérons par exemple les trois derniers étages E₄₇₉, E_{480,} E₄₈₁, avec les transistors T3 des étages E₄₇₉ et E₄₈₁ pilotés par le signal d'horloge Ck2 et le transistor T3 de l'étage E₄₈₀ piloté par le signal d'horloge Ck1.

Le signal d'horloge Ck2 étant à l'état haut Vgon, si les capacités C2 de ces étages sont préchargées, les transistors T3 des étages E₄₇₉ et E₄₈₁ vont suivre l'état du signal d'horloge Ck2. Alors le transistor de précharge T1 et le transistor T2 de l'étage E₄₈₀ sont passants, faisant circuler un courant i entre Ck2 et V- : le potentiel au noeud interne P₄₈₀ de cet étage s'établit alors à une valeur intermédiaire entre Vgon (état haut de Ck2) et V-.

Le même phénomène se produit pour toutes les lignes paires qui se retrouvent encadrées par deux lignes impaires dans les mêmes conditions.

La somme de ces courants i qui circulent dans les étages pairs à cet instant fait monter le potentiel sur le bus d'alimentation V-, à cause de l'impédance de ce bus. On a dans ces conditions un potentiel V- dont la valeur varie en fonction du rang de l'étage, en pratique entre -7 volts (Vgoff) pour le premier étage et près de +1 volt pour le dernier étage E₄₈₁ : le niveau de tension V- remonte vers le bas de l'écran.

Cette remontée de la tension V- dans le bas de l'écran a pour effet de faire moins conduire les transistors T2, et par suite favorise la montée du potentiel du noeud interne des étages concernés.

On a alors des étages pairs qui sont maintenus préchargés de manière incomplète à cause du pont diviseur (T1, T2), pendant l'état actif à Vgon du signal d'horloge Ck2. Les transistors T3 de ces étages sont ainsi légèrement passants, suffisamment pour entretenir la précharge des capacités C2 des étages impairs ; et les capacités de ces étages impairs sont plus préchargées que celle des étages pairs : les transistors T3 sont presque saturés, et celui du dernier étage est même complètement saturé.

En pratique, dans certaines conditions, on peut ainsi observer :
- la propagation d'une impulsion de sélection de pleine amplitude sur des lignes paires de l'écran : typiquement on aura par exemple la vidéo de la ligne 2 écrite sur la ligne 472, la vidéo de la ligne 4 écrite sur la ligne 470,...etc : c'est l'effet miroir.
- un remplissage progressif dans le bas de l'écran des étages du registre provoqué par cette impulsion, qui régénère les conditions de départ de l'effet miroir observé, et l'entretient.

Cet effet miroir ne peut en pratique être supprimé qu'avec l'utilisation d'une procédure spécifique d'initialisation déclenchée au démarrage de l'écran, pour obtenir la décharge de chacune des capacités de bootstrap des étages du registre. Cette procédure consiste en l'application de conditions d'adressage spécifiques pendant la phase d'initialisation de l'écran, qui peuvent être par exemple :
- maintenir les signaux Ck1, Ck2 au niveau Vgoff pendant un temps spécifique, typiquement de l'ordre d'une seconde, pour décharger les capacités C2 dites de bootstrap; ou
- forcer le signal R-last à l'état haut pendant un temps spécifique, typiquement pendant une dizaine de trames.

Le document WO 2006/013542 propose des moyens de décharge de la capacité de bootstrap intégrés dans chacun des étages du registre.

L'invention concerne ainsi un registre à décalage intégré sur le substrat de matrice active d'un écran plat, pour commander des lignes de sélection de points image de l'écran, comportant une pluralité d'étages en cascade, chaque étage étant piloté par des premier et second signaux d'horloge complémentaires et fournissant un signal de sélection de ligne sur un noeud de sortie, et chaque étage comportant un noeud interne et et les éléments suivants :
- un premier et un deuxième transistor connectés en série entre un noeud de sortie d'un étage précédent, ou d'un signal d'entrée du registre, et un bus d'alimentation négative, le point milieu de connexion entre lesdits premier et deuxième transistors étant ledit noeud interne de l'étage,
- un troisième et un quatrième transistor connectés en série entre un signal d'horloge parmi le premier et le deuxième signaux d'horloge, et un bus d'alimentation négative, la grille dudit troisième transistor étant connectée au dit noeud interne, le point milieu de connexion entre lesdits troisième et quatrième transistors étant ledit noeud de sortie,
   et lesdits deuxième et quatrième transistors étant commandés sur leur grille par le signal de sortie d'un étage suivant, ou d'un signal de commande de décharge dans le cas du dernier étage du registre, et
- une première capacité connectée entre l'autre signal d'horloge et ledit noeud interne, et une deuxième capacité connectée entre ledit noeud interne et ledit noeud de sortie,
   chaque étage comprenant des moyens de décharge de ladite deuxième capacité,
   caractérisé en ce que lesdits moyens de décharge sont activés par un signal d'activation qui est ledit signal de commande de décharge (R-last) du dernier étage et en ce que des moyens sont prévus pour forcer ce signal (R-last) à l'état actif au démarrage de l'écran.

Dans une variante, le signal d'activation des moyens de décharge pour l'étage de rang n est fourni par le noeud de sortie d'un étage de rang précédent, mais pas immédiatement précédent, avantageusement de rang n-2.

Selon un mode de réalisation de l'invention, lesdits moyens de décharge consistent en un transistor connecté en parallèle sur ladite deuxième capacité.

Selon un autre mode de réalisation de l'invention, lesdits moyens de décharge consistent en un premier transistor connecté en parallèle entre le noeud interne et ledit bus d'alimentation négative, et un deuxième transistor connecté en parallèle entre le noeud de sortie et ledit bus d'alimentation négative.

L'invention s'applique aux écrans plats à matrice active, en particulier aux écrans à cristal liquide.

D'autres avantages et caractéristiques de l'invention sont détaillés dans la description suivante en référence aux dessins illustrés d'un mode de réalisation de l'invention, donné à titre d'exemple non limitatif. Dans ces dessins :
- les figures 1a et 1 b illustrent un registre à décalage selon l'état de l'art ;
- la figure 2 est un chronogramme des signaux illustrant le fonctionnement d'un tel registre ;
- la figure 3 est un schéma d'un registre à décalage selon un premier mode de réalisation qui n'est pas revendiqué et qui sert d'exemple comparatif.
- la figure 4 illustre une première variante inventive de commande de ce registre ;
- la figure 5 illustre une deuxième variante inventive de commande de ce registre
- la figure 6 est un schéma d'un registre à décalage selon un deuxième mode de réalisation qui n'est pas revendiqué et qui sert d'exemple comparatif.
- la figure 7 illustre une première variante inventive de commande de ce registre ;
- la figure 8 illustre une deuxième variante inventive de commande de ce registre ; et
- la figure 9 illustre schématiquement un substrat de matrice active à drivers intégré.

Dans l'invention, un étage de registre à décalage comprend des moyens intégrés de décharge de la capacité de bootstrap, activés au moins une fois au démarrage de l'écran, c'est à dire à sa mise sous tension, et avantageusement, à chaque nouvelle trame vidéo.

L'invention est illustrée en référence aux figures 3 à 8 qui illustrent différentes variantes de l'invention, appliquées en exemple à un registre à décalage comprenant 481 étages E₁ à E₄₈₁ pour commander 481 lignes de sélection R(1) à R(481). Ce registre a une structure conforme à la structure de l'état de l'art décrite en relation avec les figures 1 a, 1b et 2. Elle est commandée par quatre signaux : deux signaux d'horloge complémentaires Ck1 et Ck2, un signal d'entrée IN émis par un circuit d'adressage de la matrice à chaque nouvelle trame vidéo, et un signal R-last pour commander la fin de sélection de ligne du dernier étage E₄₈₁.

Dans un premier mode de réalisation illustré sur les figures 3 à 5, ces moyens intégrés comprennent un transistor de décharge T5, connecté en parallèle sur la capacité de bootstrap C2.

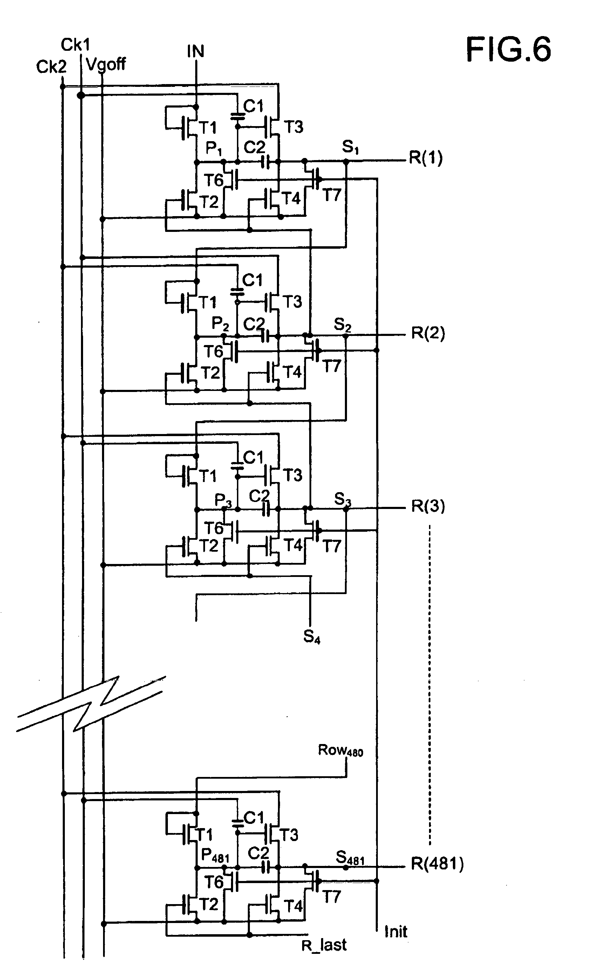

Dans un deuxième mode de réalisation, illustré sur les figures 6 à 8, ces moyens intégrés comprennent deux transistors de décharge T6 et T7 connectés chacun à une borne respective de la capacité de bootstrap C2 , et entre cette borne et la tension négative V- (ou Vgoff).

Ces moyens intégrés de décharge de la capacité de bootstrap doivent être activés au moins une fois au démarrage de l'écran.

Un mode de réalisation de cette commande est illustré sur les figures 3 et 6.

Dans ce mode, un signal d'initialisation spécifique Init est généré par un circuit d'initialisation de l'écran. Ce signal Init est appliqué sur la grille de commande du transistor de décharge T5 (Figure 3) ou des transistors de décharge T6 et T7 (Figure 6), dans tous les étages du registre à décalage.

Ce mode de réalisation oblige à prévoir une ligne conductrice supplémentaire, pour appliquer un signal généré spécifiquement pour cette fonction d'activation des moyens de décharge de la capacité de bootstrap C2.

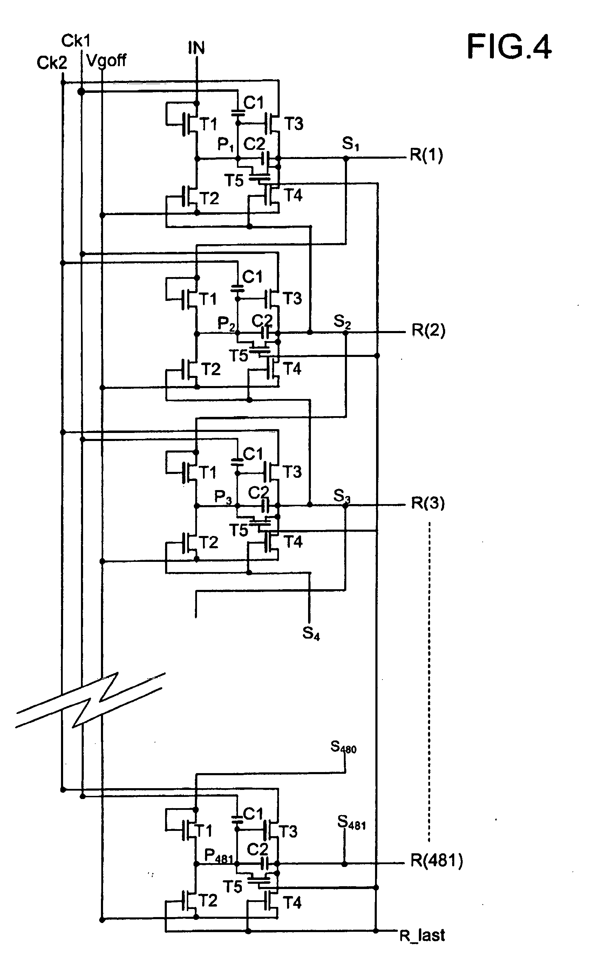

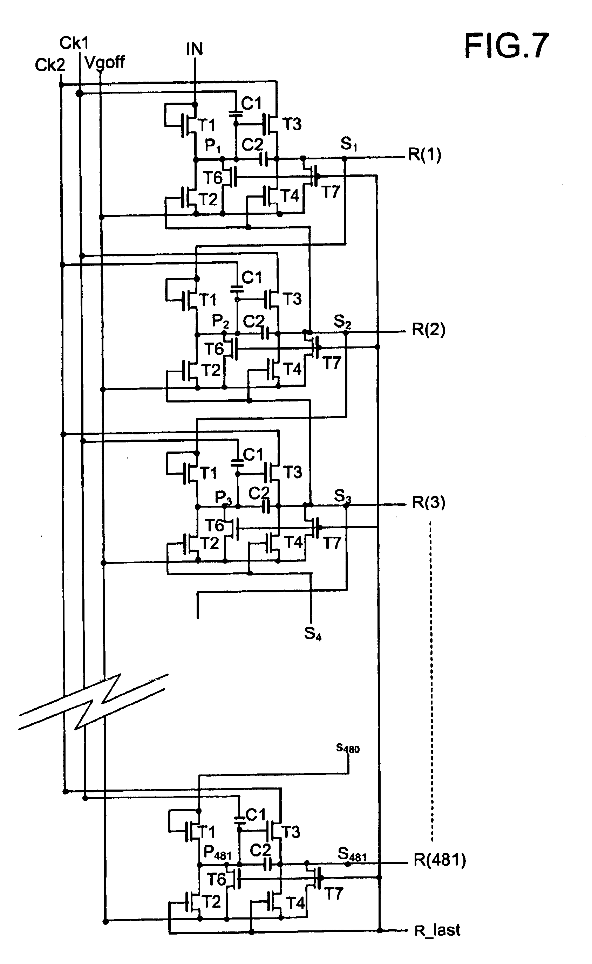

Dans un premier perfectionnement illustré sur les figures 4 et 7, on utilise avantageusement le signal R-last déjà présent. On prévoit alors de "rallonger" la ligne conductrice amenant ce signal sur le dernier étage, pour appliquer ce signal sur tous les étages.

Dans ce mode de réalisation, le signal R-last étant une impulsion marquant la fin de sélection de la dernière ligne R(481) de l'écran, qui est donc activé à chaque nouvelle trame vidéo en fin de temps trame vidéo, la décharge de la capacité de bootstrap C2 est ainsi réalisée par les moyens de décharge de l'invention en fin de chaque trame vidéo.

De préférence, on prévoit en outre que le signal R-last est activé une première fois lors du démarrage de l'écran, pour activer les moyens de décharge pendant ce démarrage.

L'utilisation d'une ligne conductrice soit supplémentaire, pour le signal Init, soit "rallongée" pour le signal R-last, et qui court tout le long du registre pour appliquer le signal d'activation des moyens de décharge sur tous les étages, entraîne une conception plus compliquée de la matrice, avec des croisements de lignes à tous les étages, nécessitant de revoir la conception de l'implantation dans la zone périphérique de la matrice active. En outre, cette variante pose un problème de charge capacitive de la ligne de commande, puisqu'elle relie les grilles de tous les transistors de décharge du registre.

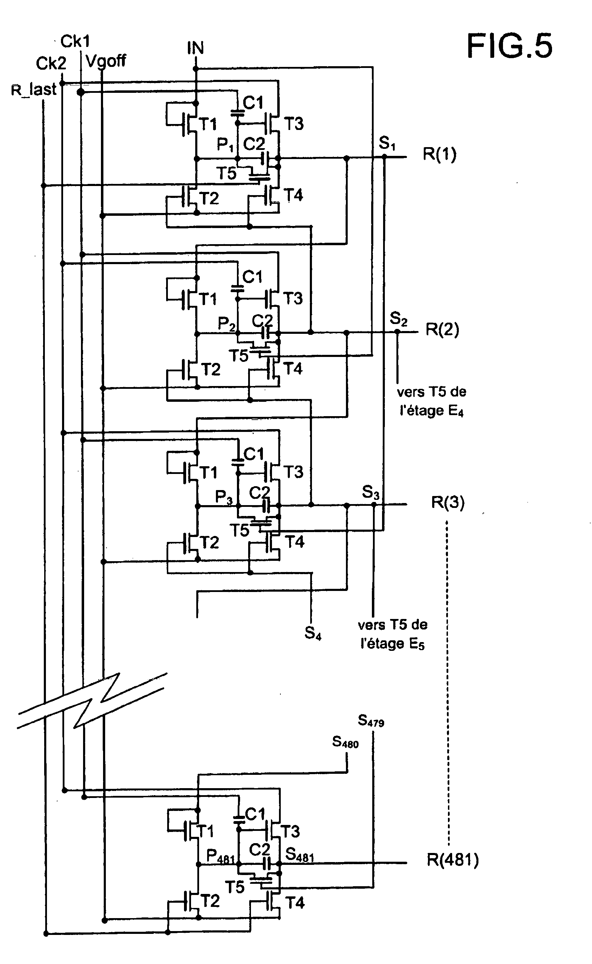

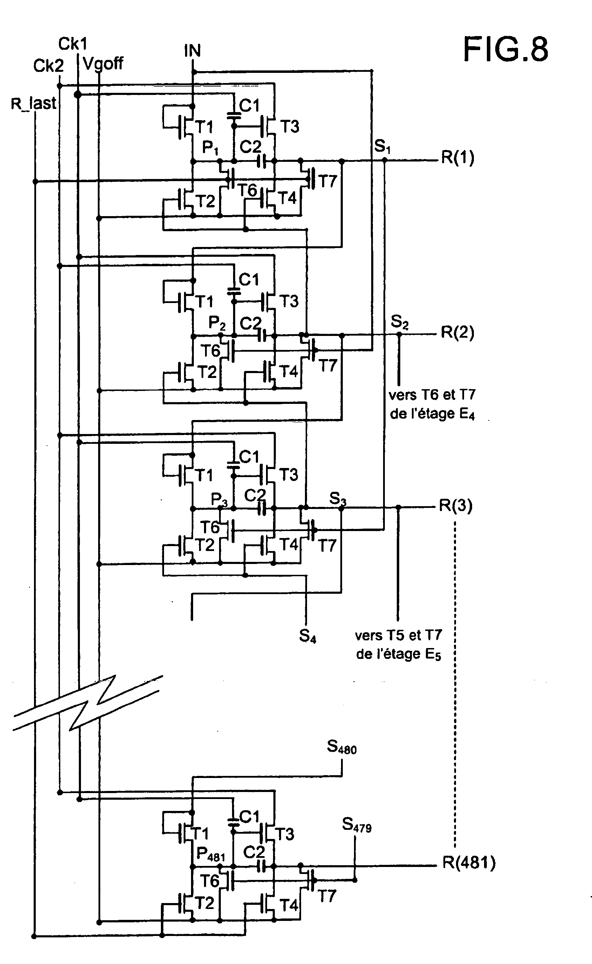

Un mode de commande optimisé est illustré sur les figures 5 et 8, qui utilise comme signal d'activation des moyens de décharge de la capacité de bootstrap C2 d'un étage, le signal de sélection de ligne d'un étage précédent mais pas immédiatement précédent. De préférence, pour un étage En, on utilisera avantageusement le signal de sélection de ligne fourni par l'étage Eₙ₋₂, au noeud de sortie Sₙ₋₂ : le signal d'activation doit provenir au moins de l'étage de rang n-2, pour ne pas écraser la précharge du noeud Pₙ interne de l'étage Eₙ du driver ; Et pour limiter le problème des croisements de lignes, on choisit avantageusement le signal fourni par l'étage le plus proche après l'étage Eₙ₋₁, soit celui fourni par l'étage Eₙ₋₂.

Ce mode de commande est avantageux, car il peut être facilement mis en oeuvre, à moindre coût, sans nécessiter de rétrofit complet des matrices actives déjà commercialisées et qu'il permet d'obtenir la décharge de la capacité de bootstrap à chaque étage, à chaque nouvelle trame vidéo.

En fonction du rang du signal d'activation retenu, les premiers étages du registre doivent être commandés d'une autre manière. Notamment, dans tous les cas il faut prévoir une activation différente pour les deux premiers étages E₁ et E₂ (il n'y a pas d'étage de "rang -1, -2, -3...)". Une solution simple et avantageuse prévoit d'utiliser les signaux disponibles, notamment d'appliquer comme signal d'activation des moyens de décharge, le signal R-last pour ces étages. Dans l'exemple illustré, le signal R-last est utilisé pour le premier étage E₁, et le signal d'entrée IN du premier étage E₁ pour le deuxième étage E₂.

L'invention s'applique aux écrans plats, notamment à cristal liquide ou OLEDs, du type à matrice active dits à drivers intégrés : comme illustré sur la figure 9, sur un même substrat S de l'écran, sont réalisés la matrice active MA, c'est à dire les électrodes pixels et leurs dispositifs de commutation associés, le circuit de commande des lignes DY et le circuit de commande des lignes DX, auquel s'applique l'invention.

## Revendications

1. Registre à décalage intégré sur le substrat de matrice active d'un écran plat, pour commander des lignes de sélection (R(n)) de points image de l'écran, comportant une pluralité d'étages en cascade (En), chaque étage (En) étant piloté par des premier et second signaux d'horloge complémentaires (Ck1, Ck2) et fournissant un signal de sélection de ligne sur un noeud de sortie (S*ₙ*), et chaque étage comprenant un noeud interne (Pₙ) et les éléments suivants :
- un premier (T1) et un deuxième transistor (T2) connectés en série entre un noeud de sortie (Sₙ₋₁) d'un étage précédent, ou d'un signal d'entrée (IN) du registre dans le cas du premier étage (E₁) du registre, et un bus d'alimentation négative (V-, V_{goff}), le point milieu de connexion entre lesdits premier et deuxième transistors étant ledit noeud interne (Pₙ) de l'étage,
- un troisième (T3) et un quatrième transistor (T4) connectés en série entre un signal d'horloge (Ck1) parmi le premier et le deuxième signal d'horloge, et un bus d'alimentation négative (V-, V_{goff}), la grille dudit troisième transistor étant connectée au dit noeud interne (Pₙ), le point milieu de connexion entre lesdits troisième et quatrième transistors étant ledit noeud de sortie (Sₙ),
et lesdits deuxième (T2) et quatrième transistors (T4) étant commandés sur leur grille par le signal de sortie (Sₙ₊₁) d'un étage suivant (Eₙ₊₁₎, ou d'un signal de commande (R-last) de décharge dans le cas du dernier étage (E₄₈₁) du registre, et
- une première capacité (C1) connectée entre l'autre signal d'horloge (Ck2) et ledit noeud interne (Pₙ), et une deuxième capacité (C2) connectée entre ledit noeud interne (Pₙ) et ledit noeud de sortie (Sₙ),
**caractérisé en ce que** chaque étage (Eₙ) comprend des moyens de décharge (T₅,T₆,T₇) de ladite deuxième capacité (C2), et **en ce que** lesdits moyens de décharge sont activés par un signal d'activation qui est ledit signal de commande de décharge (R-last) du dernier étage et **en ce que** des moyens sont prévus pour forcer ce signal (R-last) à l'état actif au démarrage de l'écran.

2. Registre à décalage intégré sur le substrat de matrice active d'un écran plat, pour commander des lignes de sélection (R(n)) de points image de l'écran, comportant une pluralité d'étages en cascade (En), chaque étage (Eₙ) étant piloté par des premier et second signaux d'horloge complémentaires (Ck1, Ck2) et fournissant un signal de sélection de ligne sur un noeud de sortie (Sₙ), et chaque étage comprenant un noeud interne (Pₙ) et les éléments suivants :
- un premier (T1) et un deuxième transistor (T2) connectés en série entre un noeud de sortie (Sₙ₋₁) d'un étage précédent, ou d'un signal d'entrée (IN) du registre dans le cas du premier étage (E₁) du registre, et un bus d'alimentation négative (V-, V_{goff}), le point milieu de connexion entre lesdits premier et deuxième transistors étant ledit noeud interne (Pₙ) de l'étage,
- un troisième (T3) et un quatrième transistor (T4) connectés en série entre un signal d'horloge (Ck1) parmi le premier et le deuxième signaux d'horloge, et un bus d'alimentation négative (V-, V_{goff}), la grille dudit troisième transistor étant connectée au dit noeud interne (Pₙ), le point milieu de connexion entre lesdits troisième et quatrième transistors étant ledit noeud de sortie (Sₙ),
et lesdits deuxième et quatrième transistors (T4) étant commandés sur leur grille par le signal de sortie (Sₙ₊₁) d'un étage suivant (Eₙ₊₁), ou
d'un signal de commande (R-last) de décharge dans le cas du dernier étage (E₄₈₁) du registre, et
- une première capacité (C1) connectée entre l'autre signal d'horloge (Ck2) et ledit noeud interne (Pₙ), et une deuxième capacité (C2) connectée entre ledit noeud interne (Pₙ) et ledit noeud de sortie (Sₙ),
**caractérisé en ce que** chaque étage (Eₙ) comprend des moyens de décharge (T₅,T₆,T₇) de ladite deuxième capacité (C2), et **en ce que** lesdits moyens de décharge d'un étage de rang n sont activés par un signal fourni par le noeud de sortie d'un étage d'un rang précédent mais pas immédiatement précédent.

3. Registre à décalage selon la revendication 2, **caractérisé en ce que** ledit rang précédent mais pas immédiatement précédent est le rang n-2.

4. Registre à décalage selon la revendication 2 ou 3, dans lequel les moyens de décharge du premier étage (E₁) du registre sont activés par ledit signal de commande de décharge (R-last) du dernier étage, et les moyens de décharge du deuxième étage (E₁) du registre sont activés par ce même signal (R-last) ou ledit signal d'entrée (IN) du registre, ledit signal de commande de décharge (R-last) étant forcé à l'état actif au démarrage de l'écran.

5. Registre selon l'une des revendications 1 à 4, **caractérisé en ce que** lesdits moyens de décharge consistent en un transistor (T5) connecté en parallèle sur ladite deuxième capacité.

6. Registre selon l'une des revendications 1 à 4, **caractérisé en ce que** lesdits moyens de décharge consistent en un premier transistor (T6) connecté en parallèle entre le noeud interne (Pₙ) et ledit bus d'alimentation négative (V-), et un deuxième transistor (T7) connecté en parallèle entre le noeud de sortie (Sₙ) et ledit bus d'alimentation négative (V-).

7. Ecran plat à matrice active, comprenant un registre à décalage selon l'une quelconque des revendications précédentes.

## Patentansprüche

1. Schieberegister, integriert auf dem Substrat der Aktivmatrix eines Flachbildschirms, zur Steuerung von Auswahllinien (R(n)) von Bildpunkten des Bildschirms, das eine Vielzahl kaskadenförmiger Etagen (Eₙ) aufweist, wobei jede Etage (Eₙ) von einem ersten und zweiten komplementären Zeitsignal (Ck1, Ck2) gesteuert wird und über einen Ausgangsknoten (Sₙ) ein Linienauswahlsignal bereitstellt, und wobei jede Etage einen internen Knoten (Pₙ) und die folgenden Elemente umfasst:
- einen ersten (T1) und einen zweiten Transistor (T2), die zwischen einem Ausgangsknoten (Sₙ₋₁) einer vorhergehenden Etage oder eines Eingangssignals (IN) des Registers im Fall der ersten Etage (E₁) des Registers und einem negativen Versorgungsbus (V-; Vgoff) in Reihe geschaltet sind, wobei der Verbindungsmittelpunkt zwischen dem ersten und zweiten Transistor der interne Knoten (Pₙ) der Etage ist,
- einen dritten (T3) und einen vierten Transistor (T4), die zwischen einem Zeitsignal (Ck1) aus dem ersten und dem zweiten Zeitsignal und einem negativen Versorgungsbus (V-; Vgoff) in Reihe geschaltet sind, wobei das Gitter des dritten Transistors mit dem internen Knoten (Pₙ) verbunden ist, wobei der Verbindungsmittelpunkt zwischen dem dritten und vierten Transistor der Ausgangsknoten (Sₙ) ist,
wobei der zweite (T2) und vierte Transistor (T4) über ihr Gitter vom Ausgangssignal (Sₙ₊₁) einer folgenden Etage (Eₙ₊₁) oder einem Entlastungs-Steuersignal (R-last) im Fall der letzten Etage (E₄₈₁) des Registers gesteuert sind, und
- eine erste Kapazität (C1), die zwischen dem anderen Zeitsignal (Ck2) und dem internen Knoten (Pₙ) geschaltet ist, und eine zweite Kapazität (C2), die zwischen dem internen Knoten (Pₙ) und dem Ausgangsknoten (Sₙ) geschaltet ist,
**dadurch gekennzeichnet, dass** jede Etage (Eₙ) Entlastungsmittel (T₅, T₆, T₇) der zweiten Kapazität (C2) umfasst und dass die Entlastungsmittel von einem Aktivierungssignal aktiviert werden, das das Entlastungs-Steuersignal (R-last) der letzten Etage ist und dass Mittel vorgesehen sind, um dieses Signal (R-last) beim Starten des Bildschirms in den aktiven Zustand zu zwingen.

2. Schieberegister, integriert auf dem Substrat der Aktivmatrix eines Flachbildschirms, zur Steuerung von Auswahllinien (R(n)) von Bildpunkten des Bildschirms, das eine Vielzahl kaskadenförmiger Etagen (Eₙ) aufweist, wobei jede Etage (Eₙ) von einem ersten und einem zweiten komplementären Zeitsignal (Ck1, Ck2) gesteuert wird und über einen Ausgangsknoten (Sₙ) ein Linienauswahlsignal bereitstellt, und wobei jede Etage einen internen Knoten (Pₙ) und die folgenden Elemente umfasst:
- einen ersten (T1) und einen zweiten Transistor (T2), die zwischen einem Ausgangsknoten (Sₙ₋₁) einer vorhergehenden Etage oder eines Eingangssignals (IN) des Registers im Fall der ersten Etage (E₁) des Registers und einem negativen Versorgungsbus (V-; Vgoff) in Reihe geschaltet sind, wobei der Verbindungsmittelpunkt zwischen dem ersten und zweiten Transistor der interne Knoten (Pₙ) der Etage ist,
- einen dritten (T3) und einen vierten Transistor (T4), die zwischen einem Zeitsignal (Ck1) aus dem ersten und dem zweiten Zeitsignal und einem negativen Versorgungsbus (V-; Vgoff) in Reihe geschaltet sind, wobei das Gitter des dritten Transistors mit dem internen Knoten (Pₙ) verbunden ist, wobei der Verbindungsmittelpunkt zwischen dem dritten und vierten Transistor der Ausgangsknoten (Sₙ) ist,
wobei der zweite und vierte Transistor (T4) über ihr Gitter vom Ausgangssignal (Sₙ₊₁) einer folgenden Etage (Eₙ₊₁) oder einem Entlastungs-Steuersignal (R-last) im Fall der letzten Etage (E₄₈₁) des Registers gesteuert sind, und
- eine erste Kapazität (C1), die zwischen dem anderen Zeitsignal (Ck2) und dem internen Knoten (Pₙ) geschaltet ist, und eine zweite Kapazität (C2), die zwischen dem internen Knoten (Pₙ) und dem Ausgangsknoten (Sₙ) geschaltet ist,
**dadurch gekennzeichnet, dass** jede Etage (Eₙ) Entlastungsmittel (T₅, T₆, T₇) der zweiten Kapazität (C2) umfasst und dass die Entlastungsmittel einer Etage des Rangs n von einem Signal aktiviert werden, das vom Ausgangsknoten einer Etage eines vorhergehenden, aber nicht des unmittelbar vorhergehenden Rangs, geliefert wird.

3. Schieberegister nach Anspruch 2, **dadurch gekennzeichnet, dass** der vorhergehende, aber nicht der unmittelbar vorhergehende Rang der Rang n-2 ist.

4. Schieberegister nach Anspruch 2 oder 3, wobei die Entlastungsmittel der ersten Etage (E₁) des Registers vom Entlastungs-Steuersignal (R-last) der letzten Etage aktiviert werden und die Entlastungsmittel der zweiten Etage (E₁) des Registers von demselben Signal (R-last) oder dem Eingangssignal (IN) des Registers aktiviert werden, wobei das Entlastungs-Steuersignal (R-last) beim Starten des Bildschirms in den aktiven Zustand gezwungen wird.

5. Register nach einem der Ansprüche 1 bis 4, **dadurch gekennzeichnet, dass** die Entlastungsmittel aus einem Transistor (T5) bestehen, der parallel auf der zweiten Kapazität geschaltet ist.

6. Register nach einem der Ansprüche 1 bis 4, **dadurch gekennzeichnet, dass** die Entlastungsmittel aus einem ersten Transistor (T6) bestehen, der parallel zwischen dem internen Knoten (Pₙ) und dem negativen Versorgungsbus (V-) geschaltet ist und einem zweiten Transistor (T7), der parallel zwischen dem Ausgangsknoten (Sₙ) und dem negativen Versorgungsbus (V-) geschaltet ist.

7. Flachbildschirm mit Aktivmatrix, der ein Schieberegister nach einem der vorangehenden Ansprüche umfasst.

## Claims

1. A shift register integrated on the active-matrix substrate of a flat screen, for controlling selection rows (R(n)) for image points of the screen, comprising a plurality of stages in cascade (Eₙ), each stage (Eₙ) being driven by first and second complementary clock signals (Ck1, Ck2) and providing a row selection signal on an output node (S*ₙ*), and each stage comprising an internal node (Pₙ) and the following elements:
- a first (T1) and a second transistor (T2) connected in series between an output node (Sₙ₋₁) of a previous stage, or a node of an input signal (IN) of the register in the case of the first stage (E1) of the register, and a negative power supply bus (V-, Vgoff), the midpoint of connection between said first and second transistors being said internal node (Pₙ) of the stage,
- a third (T3) and a fourth transistor (T4) connected in series between a clock signal (Ck1) from among the first and the second clock signal, and a negative power supply bus (V-, Vgoff), the gate of said third transistor being connected to said internal node (Pₙ), the midpoint of connection between said third and fourth transistors being said output node (S*ₙ*),
and said second and fourth transistor (T4) being controlled on their gate by the output signal (Sₙ₊₁) of a following stage (Eₙ₊₁), or for a discharge control signal (R-last) in the case of the last stage (E₄₈₁) of the register, and
- a first capacitor (C1) connected between the other clock signal (Ck2) and said internal node (Pₙ), and a second capacitor (C2) connected between said internal node (Pₙ) and said output node (S*ₙ*),
**characterized in that** each stage (Eₙ) comprises discharge means (T5, T6, T7) for said second capacitor (C2), and said discharge means are activated by an activation signal which is the said discharge control signal (R-last) of the last stage and **in that** means are designed to force this signal (R-last) to the active state when the screen starts up.

2. A shift register integrated on the active-matrix substrate of a flat screen, for controlling selection rows (R(n)) for image points of the screen, comprising a plurality of stages in cascade (Eₙ), each stage (Eₙ) being driven by first and second complementary clock signals (Ck1, Ck2) and providing a row selection signal on an output node (S*ₙ*), and each stage comprising an internal node (Pₙ) and the following elements:
- a first (T1) and a second transistor (T2) connected in series between an output node (Sₙ₋₁) of a previous stage, or a node of an input signal (IN) of the register in the case of the first stage (E1) of the register, and a negative power supply bus (V-, Vgoff), the midpoint of connection between said first and second transistors being said internal node (Pₙ) of the stage,
- a third (T3) and a fourth transistor (T4) connected in series between a clock signal (Ck1) from among the first and the second clock signal, and a negative power supply bus (V-, Vgoff), the gate of said third transistor being connected to said internal node (Pₙ), the midpoint of connection between said third and fourth transistors being said output node (S*ₙ*),
and the said second and fourth transistors (T4) being controlled on their gate by the output signal (Sₙ₊₁) of a following stage (Eₙ₊₁), or for a discharge control signal (R-last) in the case of the last stage (E₄₈₁) of the register, and
- a first capacitor (C1) connected between the other clock signal (Ck2) and said internal node (Pₙ), and a second capacitor (C2) connected between said internal node (Pₙ) and said output node (S*ₙ*),
**characterized in that** each stage (Eₙ) comprises discharge means (T5, T6, T7) for said second capacitor (C2), said discharge means of a stage of rank n are activated by a signal provided by the output node of a stage of a previous but not immediately previous rank.

3. The shift register as claimed in claim 2, **characterized in that** said previous but not immediately previous rank is the rank n-2.

4. The shift register as claimed in claim 2 or 3, in which the discharge means of the first stage (E₁) of the register are activated by said discharge control signal (R-last) of the last stage, and the discharge means of the second stage (E₁) of the register are activated by this same signal (R-last) or said input signal (IN) of the register, said discharge control signal (R-last) being forced to the active state when the screen starts up.

5. The register as claimed in one of claims 1 to 4, **characterized in that** said discharge means consist of a transistor (T5) connected in parallel with said second capacitor.

6. The register as claimed in one of claims 1 to 4, **characterized in that** said discharge means consist of a first transistor (T6) connected in parallel between the internal node (Pₙ) and said negative power supply bus (V-), and a second transistor (T7) connected in parallel between the output node (Sₙ) and said negative power supply bus (V-).

7. An active-matrix flat screen, comprising a shift register as claimed in any one of the preceding claims.
